(19) Europäisches Patentamt
European Patent Office
Office européen des brevets

(11) Veröffentlichungsnummer: **0 231 857 B1**

(12) # EUROPÄISCHE PATENTSCHRIFT

(45) Veröffentlichungstag der Patentschrift: **13.03.91**

(51) Int. Cl.⁵: **G11B 7/24**, G11C 13/04

(21) Anmeldenummer: **87101082.3**

(22) Anmeldetag: **27.01.87**

(54) **Verfahren zur reversiblen, optischen Datenspeicherung (III).**

(30) Priorität: **04.02.86 DE 3603268**

(43) Veröffentlichungstag der Anmeldung:
**12.08.87 Patentblatt 87/33**

(45) Bekanntmachung des Hinweises auf die Patenterteilung:
**13.03.91 Patentblatt 91/11**

(84) Benannte Vertragsstaaten:
**DE FR GB IT NL**

(56) Entgegenhaltungen:
**EP-A- 0 007 574**
**EP-A- 0 141 512**
**EP-A- 0 171 045**
**DE-A- 3 324 770**
**DE-B- 2 740 076**

**THE TRANSACTIONS OF THE IECE OF JAPAN, Band E61, Nr. 6; K. KUBOTA et al.: "Hologram memory using one dimensional Fourier transform-image hologram"**

(73) Patentinhaber: **Röhm GmbH**
**Kirschenallee Postfach 4242**
**W-6100 Darmstadt 1(DE)**

(72) Erfinder: **Eich, Manfred**
**Bockenheimer Landstrasse 7**
**W-6000 Frankfurt 1(DE)**
Erfinder: **Wendorff, Joachim, Dr.**
**Reiherstrasse 18**
**W-6085 Nauheim(DE)**
Erfinder: **Reck, Bernd**
**L 13,6**
**W-6800 Mannheim(DE)**

**EP 0 231 857 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Gebiet der Erfindung

Die Erfindung betrifft eine Vorrichtung zur reversiblen, optischen Datenspeicherung unter Verwendung von polymeren Flüssigkristallen.

Stand der Technik

Zwischen der festen kristallinen Phase und der fluiden Schmelze, im folgenden als isotrope Schmelze gekennzeichnet, treten in bestimmten Substanzen Zwischenphasen auf, die in struktureller und dynamischer Hinsicht Eigenschaften sowohl des geordneten kristallinen Zustands als auch des ungeordneten Schmelzzustandes in sich vereinigen. So sind diese Phasen zwar fluide, weisen aber z.B. optische Eigenschaften auf, die charakteristisch für die Mehrzahl kristalliner aber auch teilkristalliner Stoffe sind: sie sind doppelbrechend. Man spricht aus unmittelbar einsehbaren Gründen von Zwischenphasen (Mesophasen) oder auch von flüssig-kristallinen Phase. Diese Zwischenphasen sind über eine Temperaturvariation zu erhalten - in diesem Fall spricht man von thermotropen Flüssigkristallen - oder auch in Lösung über Konzentrationsvariationen. Im folgenden sollen nur thermotrope Flüssigkristalle betrachtet werden. Zur Charakterisierung der Existenzbereiche dieser Zwischenphasen gibt man im allgemeinen die z. B. kalorimetrisch oder mittels Polarisationsmikroskop bestimmten Übergangstemperaturen vom kristallinen Zustand in den flüssig-kristallinen Zustand sowie vom flüssig-kristallinen Zustand in den der isotropen Schmelze (Klärpunkt) an. Ferner wird beim Vorliegen unterschiedlicher flüssig-kristalliner Zustände der Satz der entsprechenden Übergangstemperaturen angegeben. Das Auftreten von Mesophasen ist gekoppelt mit Besonderheiten in der Molekülgeometrie. Sphärisch symmetrische Moleküle können keine Mesophasen ausbilden, wohl aber Moleküle ,deren Gestalt sich grob als zylinderförmig oder scheibchenförmig charakterisieren läßt. Dabei können die Moleküle starr sein und das Verhältnis ihrer maximalen zu ihrer minimalen Abmessung (z. B. Zylinderlänge/Zylinderdurchmesser) muß einen kritischen Wert von ca. 3 deutlich überschreiten.

Die Struktur solcher Mesophasen ist nun dadurch gekennzeichnet, daß im einfachsten Fall für zylinderförmige Moleküle, in der sog. nematischen Phase, die Molekülzentren ungeordnet wie in einer isotropen Schmelze verteilt sind, während die Längsachsen der Moleküle parallel zueinander orientiert sind. Das ist abweichend vom Zustand in der isotropen Schmelze, wo die Molekülachsen statistisch verteilt vorliegen. Die Folge sind anisotrope mechanische, elektrische aber auch optische Eigenschaften. Bei der cholesterischen Phase kommt als zusätzliches Ordnungsprinzip eine kontinuierliche helikale Variation der Orientierungsrichtung der Moleküllängsachsen hinzu, was zu besonderen optischen Eigenschaften, wie starke optische Aktivität oder Selektivreflektion von Licht fürht. Bei den sogenannten smektischen Phasen tritt schließlich in Ergänzung zu der bereits beschriebenen Orientierungsordnung, wie sie für den nematischen Zustand charakteristisch ist, eine regelmäßige Anordnung der Molekülschwerpunkte im Raum hinzu, z. B. nur entlang einer räumlichen Achse aber auch, in anderen smektischen Modifikationen, entlang zwei oder gar drei voneinander unabhängigen Achsen. Dennoch sind diese Phasen fluide. Scheibchenförmige Moleküle vermögen sogenannte diskotische Phasen auszubilden, in denen entweder nur die Scheibchennormalen parallel zueinander orientiert sind ( vgl. nematische Phase) oder aber in denen die Scheibchen innerhalb von Säulen in regelmäßiger oder unregelmäßiger Weise angeordnet sind. Man spricht von kolumnaren Strukturen in diesem Fall.

Eine charakteristische und für die Anwendung sehr wichtige Größe flüssig-kristalliner Strukturen ist der Orientierungsordnungsparameter, der ein Maß für die Güte der Orientierungsordnung ist.
Sein Wert liegt zwischen 0 bei vollständiger Desorientierung (wie in der isotropen Schmelze) und 1 bei perfekter Parallelorientierung aller molekularer Längsachsen.

Die weite Verbreitung von flüssig-kristallinen Substanzen in technischen Produkten wie Anzeigeelementen, in Taschenrechnern, Armbanduhren oder digitalen Meßgeräten beruht auf der Eigenart, daß sich die Orientierungsrichtung, die sich durch den sogenannten Direktor repräsentieren läßt, durch von außen einwirkende elektrische, magnetische oder mechanische Felder leicht verändern läßt. Die dadurch bedingten Veränderungen in den optischen Eigenschaften lassen sich in Kombination mit weiteren Komponenten wie Polarisatoren, Zellenwänden usw. in Anzeigeelementen zur Informationsdarstellung verwenden. Die Zellenwände dienen dabei dem Schutz der fluiden Mesophasen und geben die geforderte makroskopische Gestalt des Flüssigkristallfilms vor.

In den letzten Jahren hat man erkannt, daß es für viele Anwendungsgebiete vorteilhaft sein kann, die Eigenschaften von flüssigkristallinen Phasen mit denen von Polymeren zu kombinieren. Die vorteilhaften

Polymereigenschaften sind dabei gute mechanische Eigenschaften, was die Herstellung dünner, formstabiler Filme aus solchen Substanzen möglich macht sowie das Auftreten eines Einfriervorgangs (Glasübergang) was das Fixieren einer vorgegebenen Orientierungsstruktur möglich macht. Die Angabe der z. B. kalorimetrisch ermittelbaren Glastemp eratur $T_g$ dient zur Kennzeichnung des Existenzbereiches der festen flüssig-kristallinen Phase. Oberhalb dieser Temperatur weist das Polymere einen viskoelastischen oder zähplastischen Zustand auf.

Theorien zur Ausbildung flüssig-kristalliner Phasen allgemein und zur Ausbildung solcher Phasen in Polymersystemen im besonderen sowie experimentellen Befunde zeigen, daß der Weg zu flüssigkristallinen Polymeren über die Verwendung von starren mesogenen Struktureinheiten, wie sie für niedrigmolekulare Flüssigkristalle charakteristisch sind, in Verbindung mit flexiblen Spacergruppen und flexiblen Kettenmolekülen führt. Dabei sind sehr unterschiedliche Bauprinzipien möglich. Die mesogenen Gruppen sind bei der Klasse der Seitenketten-Flüssigkristalle über einen flexiblen Spacer, gegebenenfalls auch ohne diesen Spacer, an einer flexiblen oder semiflexiblen Hauptkette fixiert. Bei den mesogenen Gruppen kann es sich dabei um zylinderförmige oder scheibchenförmige handeln. Die Hauptkette kann dabei auch mesogene Gruppen enthalten, die durch flexible Einheiten getrennt sind. Copolymere, dadurch charakterisiert, daß innerhalb **eines** Polymeren verschiedene Spacer und/oder mesogene Gruppen auftreten, können ebenfalls flüssig-kristalline Phasen ausbilden.

Neben diesen Seitenketten-Flüssigkristallen zeigen auch Hauptkettenpolymere unter bestimmten Bedingungen flüssig-kristalline Phasen. Die Bedingungen hierfür sind, daß die Ketten entweder vollständig aus starren Gruppen aufgebaut sind, oder aber aus starren und flexiblen Gruppen. Copolymere aus verschiedenen mesogenen Gruppen und/oder Spacergruppen vermögen ebenfalls flüssig-kristalline Phasen auszubilden. Die mesogenen Gruppen können eine eher zylinderförmige bzw. eine eher stäbchenförmige Gestalt aufweisen. Die Natur der Mesophasen sowie die Existenzbereiche dieser Phasen sowie des Glaszustands lassen sich über die Struktur der mesogenen Gruppen, über die Spacerlänge und -flexibilität, die Flexibilität der Hauptkette sowie über deren Taktizität und Länge näherungsweise einstellen.

In den Markt eingeführt sind bisher praktisch nur Hauptkettenpolymere mit ausschließlich starren Einheiten(gemäß BI)oder mit überwiegend starren Einheiten. Sie weisen extrem hohe Werte für die Festigkeit und die Steifigkeit auf. Man spricht von sich selbst verstärkenden thermoplastischen Kunststoffen. Ihr Einsatzgebiet sind technische Teile, in denen extreme mechanische Eigenschaften gefordert sind. (Vgl. Kirk-Othmer, Encyclopedia of Chemical Technology, 3rd. Ed. Vol 14 , pg. 414 - 421, (1984); J.H. Wendorff, Kunststoffe 73 , 524 - 528 (1983); M.G. Dobb, J.E. McIntyre Adv. Polym. Sci. 60/61 , 61 - 98 (1984).

Polymere mit flexiblen und starren Einheiten haben noch nicht in auf dem Markt eingeführten Systemen Verwendung gefunden. Ihr Vorteil besteht in einem, im Vergleich zu Seitenketten-Flüssigkristallen hohen Wert des Orientierungsordnungsparameters (Vgl. C. Noel, F. Laupretre, C. Friedrich, B. Fagolle, L. Bosio, Polymer 25 , 808 - 814 (1984); B. Wunderlich, I. Grebowicz Adv. Polymer. Sci. 60/61 , 1 - 60 (1984). Auch die Polymeren mit mesogenen Seitengruppen fanden in jüngerer Zeit stärkere Beachtung (Vgl. H. Finkelmann in "Polymer Liquid Crystals" Academic Press (1982); H. Finkelmann, G. Rehage Adv. Polym. Sci. 60/61 , 99 - 172 (1984); V.P. Shibaev, N.A. Platé Adv. Polym. Sci. 60/61 , 173 - 252 (1984).

Aus der US-A 4 293 435 ist eine technische Nutzung des spezifischen Verhaltens der flüssigkristallinen Polymere, das mit dem Übergang in den Glaszustand verbunden ist, bekannt. Dabei wird durch Anwendung von Bedingungen, die in definierter Weise Anordnung und Orientierung der flüssigkristallinen Polymeren verändern (wie z. B. elektrisches und magnetisches Feld bzw. Druck) Information gespeichert. Dieser Stand der Technik wird in der GB-A 2 146 787 diskutiert. Es wird darauf hingewiesen, daß die in der US-A vorgesehene Lagerung der Vorrichtung im Festzustand unterhalb Glastemperatur ($T_g$) bedeutet, daß $T_g$ oberhalb der üblichen Raumtemperatur ($T_a$) liegt, d. h. daß das Polymersystem bei Temperaturen zur Anwendung kommt, die in der Größenordnung von 100 °C über $T_a$ liegen, will man innerhalb vernünftiger Zeiten die Information aufnehmen. Solche Temperaturen sei en unhandlich und brächten auf längere Sicht einen Abbau des Polymeren mit sich. Diese Schwierigkeiten lassen sich nach der GB-A vermeiden, wenn man bestimmte polymere Seitenketten-Flüssigkristalle verwendet. Dann ist es nicht länger notwendig,zur Aufbewahrung der Vorrichtung einen Temperaturbereich unterhalb der $T_g$ einzuhalten, sondern eine stabile Speicherung über viele Jahre hinweg soll bei Temperaturen oberhalb $T_g$ und unterhalb einer Temperatur ($T_f$), bei der das Polymermaterial flüssig zu werden beginnt,möglich sein.

Die Bestimmung der $T_f$ kann durch Verfolgung des Lichtdurchgangs durch ein flüssigkristallines Polymer zwischen zwei gekreuzte Polarisationsfiltern mit ab Glastemperatur ansteigender Temperatur vorgenommen werden. Einige Grade unterhalb des smektisch-isotropen Phasenübergangs steigt die Lichtdurchlässigkeit plötzlich an. Dieser Anstieg rührt vom Übergang eines anisotropen aber wenig durchlässigen zu einem hochgradig doppelbrechenden, durchlässigen Zustand des Bereichs her. Der Temperaturbereich oberhalb dieser Temperatur $T_f$ wird als "flüssiger Bereich" (fluid region) bezeichnet. Mit steigender

Temperatur steigt auch die Lichtdurchlässigkeit an, bis sie bei einer $T_m$ ihr Maximum erreicht. Die $T_m$ markiert den Punkt, an dem die isotrope (Klar-)Phase zuerst auftritt.
Da das Auftreten der isotropen Phase bei gekreuzten Polarisatoren zu einer Extinkion des Lichts führt, bringt eine weitere Temperaturerhöhung einen Abfall des Lichtdurchtritts in dem Maße mit sich, wie die isotropen Bezirke in der Größe anwachsen, bis die sogenannte Klärtemperatur ($T_c$) erreicht ist, bei der die letzten Reste der für die Doppelbrechung verantwortlichen Struktur verschwunden sind.

In der GB-A 2 146 787 wird eine Vorrichtung beansprucht mit einer Materialschicht, die ein flüssigkristallines Polymeres mit mesogener Seitenkette enthält, sowei Einrichtungen zum thermischen Überführen mindestens eines Teils des Materials aus dem viskosen Zustand, bei dem sich die Temperatur des Materials im Bereich $T_g$ bis $T_f$ befindet, in den flüssigen Bereich und Einrichtungen zur Beeinflussung mindestens eines Teils des Materials im flüssigen Bereich, womit man eine selektive Veränderung in der Textur der Moleküle im Material hervorruft und dadurch Information eingibt, die auch nach Abkühlung des flüssigen Bereichs und Rückkehr in den viskosen Zustand erhalten bleibt. Für die GB-A ist es somit eine essentielle Voraussetzung, Polymermaterial zu verwenden für das gilt: $T_f > T_a > T_g$. Ferner wird eine Vorrichtung beschrieben, in der die Materialschicht ein flüssigkristallines Polymer mit einer smektogenen Seitenkette enthält. Besonders bevorzugt sind polymere Flüssigkristalline vom Polysiloxan-Typ mit Diphenylcyan-Seitenketten oder Benzoesäureester-Seitenketten.

## Aufgabe und Lösung

Nach wie vor besteht ein großes Interesse an optischen Speichermedien, die neben hohen Aufzeichnungsdichten auch die Möglichkeit zur reversiblen Speicherung besitzen. Die vorstehend erläuterten Lösungen des Problems der optischen Datenspeicherung stellen relativ eng begrenzte technische Lösungen dar. So beruht die Vorrichtung gemäß der GB-A auf der Anwendung von flüssigkristallinen Seitenkettenpolymeren mit der essentiellen Voraussetzung, daß die Temperatur *) Polymermaterial in einem viskosen Zustandsbereich gehalten wird. Die differenzierte Offenbarung erstreckt sich auf Polysiloxan-Flüssigkristalle, vorzugsweise mit Diphenylcyan- oder Benzoesäureester-Seitenketten. Die Stabilität der eingespeicherten Information ist wegen der vorhandenen Molekülbeweglichkeit und der endlichen Relaxationszeiten als auch durch die Möglichkeit der Beeinflussung des Systems z.B. durch äußere Störfelder nicht eindeutig gewährleistet. Zu wünschen waren weiterhin technische Lösungen, deren Realisierung innerhalb eines nicht zu engen Spielsraums durchführbar sein sollte.

Die vorliegende Erfindung betrifft somit ein Verfahren zur reversiblen optischen Informationsspeicherung in einem flüssigkristallinen Speichermedium mit mesogenen Seitengruppen mittels Laserlicht, bei dem mittels linear polarisiertem Laserlicht über einen optisch nichtlinearen Effekt, auf Grund der positiven Polarisationsanisotropie der verwendeten Flüssigkristalle der selektiv zu einer Variation der räumlichen Orientierung der mesogenen Gruppen in einem Film aus einem flüssigkristallinen Seitenkettenpolymeren führt und eine lokale Änderung des Brechungsindex zur Folge hat, Information in Form eines optisch anisotropen Phasenobjektes eingespeichert wird, wobei der Film beim Einspeichern der Information im formstabilen Bereich unterhalb der Glastemperatur Tg der polymeren Flüssigkristalle oder im viskoelastischen Zustand oberhalb der Glastemperatür, aber unterhalb des Übergangs von flüssigkristallin in isotrop, der polymeren Flüssigkristalle in einer anisotropen Phase befindet. Der die Information enthaltende lokale Orientierungszustand bleibt nach Abschalten des Laserstrahls unterhalb Tg der polymeren Flüssigkristalle eingefroren. Zweckmäßig ist das Speichermedium, enthaltend polymere Flüssigkristalle mit mesogenen Seitenketten, Teil einer entsprechend eingerichteten Vorrichtung.
Die Anforderungen an die Struktur der flüssigkristallinen Polymere für die verschiedenen Orientierungsverfahren sind in der Literatur dukumentiert. So erfordert zum Beispiel eine homöotrope Orientierung im elektrischen Feld eine positive Dielektrizitätsanisotropie für den verwendeten Frequenzbereich. Eine homogene Orientierung hingegen läßt sich häufig durch Begrenzungsoberflächen aus strukturiertem Polyimid erzeugen. Hierfür sind mesogene Gruppen mit anisotroper Form erforderlich.
Vgl. R. Kelker, R. Hatz Handbook of Liquid Crystals Verlag Chemie 1981. Vgl. Pranoto, W. Haase Mol Cryst. Liq. Crist. 98 , 299 - 308 (1983) R. Zentel, R. Ringsdorf, makromol. Chem. 182 , 1245 - 1256 (1982) Vgl. Liquid Crystals and Ordered Fluids. A. Griffin & J.F. Johnson, Vol. 4 , Plenum Press, New York 1984

Die erfindungsgemäß verwendbaren polymeren Flüssigkristalle PFK bestehen ganz oder teilweise aus repetierenden Einheiten, die schematisch durch die allgemeine Formel I

*) so gewählt wird, daß das

$$-\left[A - \underset{\underset{X\ -\ Y}{|}}{B} -\right] \qquad I$$

wiedergegeben werden können, wobei A - B die Elemente der Hauptkette des Polymerisats, X eine abstandhaltende Einheit ("Spacer") und Y eine mesogene Seitengruppe bezeichnet.

Dabei sind die mesogenen Seitengruppen verantwortlich für den resultierenden Flüssig-Kristall-Charakter. Von besonderem Interesse sind Seitenketten vom smektogenen Typ.
Die Elemente A - B entsprechen dabei vorzugsweise radikalisch polymeris ierbaren Einheiten A' = B' - (entsprechendes Monomeres: A' = B' - X - Y).

Bevorzugt handelt es sich bei den Einheiten A' - B' um Vinylgruppen, wie sie in den radikalisch polymerisierbaren Vinylverbindungen vorliegen, zum Beispiel um Einheiten

$$H_2C = \overset{\overset{R_1}{|}}{C} - Q -$$

worin $R_1$ für Wasserstoff oder Methyl und Q für eine die Doppelbindung aktivierende Funktion wie die Gruppe

$$-\overset{\overset{O}{\parallel}}{C} - O -; \quad -\overset{\overset{O}{\parallel}}{C} - \overset{\overset{R_2}{|}}{N} -; \quad -\overset{\overset{O}{\parallel}}{C} -; \quad -C_6H_5 -$$

steht, worin $R_2$ die Bedeutung Wasserstoff oder Alkyl mit 1 bis 6 Kohlenstoffatomen besitzt.

Die Spacergruppe X stellt eine (flexible) Kette mit 1 - 14 Kettengliedern dar, vorzugsweise eine Alkylengruppe $-(CH_2)_n-$ worin n für 1 bis 14 steht, wobei gegebenenfalls einzelne Kettenglieder substituiert sein können, beispielsweise durch Halogen wie Chlor oder durch eine Ätherbrücke ersetzt sein können.
Die mesogenen Seitenkette Y enthält gegebenenfalls eine die Spacergruppe X mit der eigentlichen mesogenen Gruppe M verknüpfende Funktion V F wie

z. B. eine $-O-;\quad -\overset{\overset{O}{\parallel}}{C}-O-;\quad -\overset{\overset{O}{\parallel}}{C}-\underset{\underset{R_2}{|}}{N}-;\quad -O-\overset{\overset{O}{\parallel}}{C}-;$ oder

$$-\underset{\underset{R_2}{|}}{N}-\overset{\overset{O}{\parallel}}{C}-$$

Gruppe, worin $R_2$ die oben beschriebene Bedeutung besitzt.

Weiter gilt für die mesogene Seitengruppe Y das folgende:
Eine Aufstellung geeigneter mesogener Gruppen findet sich in Kelker and Hatz, Handbook of Liquid Crystals, Verlag Chemie 1980, pp. 67 - 113.
Vorzugsweise über die genannte verknüpfende Funktion VF gebunden ist eine beispielsweise aromatische Reste enthaltende mesogene Gruppe M, die vorzugsweise durch die Formel

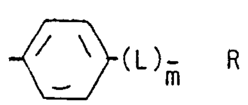

II

wiedergegeben werden kann, worin L für eine Brücke, bestehend aus den Resten

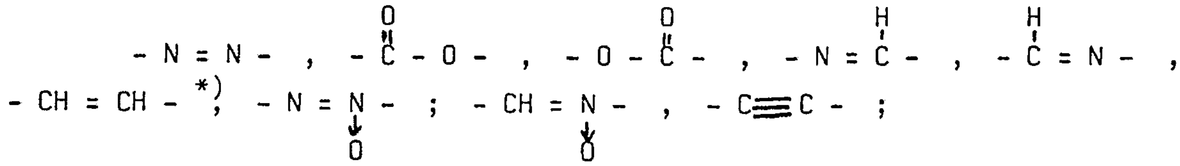

*) oder für einen Rest

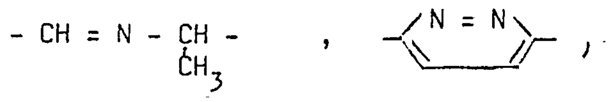

m für Null oder eins und R für einen Rest

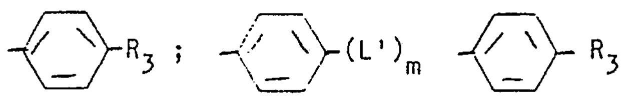

oder falls m für Null steht R auch für einen Rest

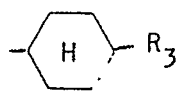

steht und L' und m' die gleichen Bedeutung wie L bzw. m besitzen und worin $R_3$ für Wasserstoff

$$(O)_r-(CH_2)_pH, \quad -COO(CH_2)_{p'}H,$$

- CN oder Halogen, insbesondere Fluor, Chlor oder Brom und p und p' für eine Zahl von 1 bis 8, insbesondere 1 bis 6, und r für Null oder 1 steht.

Besonders genannt seien Polymere der Formel I, worin M für die folgenden mesogenen Gruppen steht:

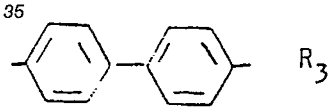 (Formel IA) ; 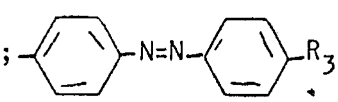 (Formel IB)

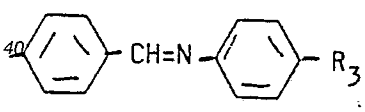 (Formel IC) ; 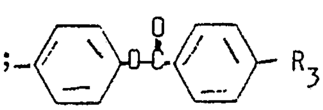 (Formel ID)

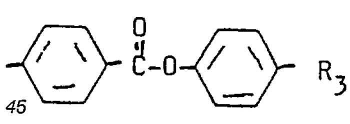 (Formel IE) ; 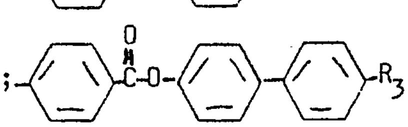 (Formel IF)

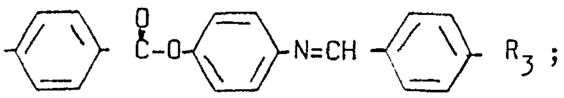

(Formel IG)

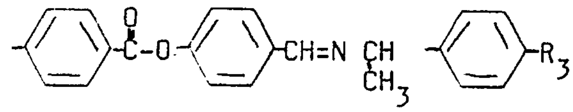

(Formel IH)

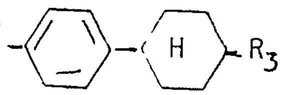

(Formel IJ)

Bevorzugt sind ferner Derivate der (Meth)acrylsäure (A' = B' - steht dabei für

$$CH_2 = \underset{R_1}{\underset{|}{C}} - CO - O \quad \text{bzw.} \quad CH_2 = \underset{R_1}{\underset{|}{C}} - CO - \underset{R_2}{\underset{|}{N}} - )$$

und solche Derivate, bei denen der Spacer X eine $-(CH_2)_n-$ Gruppe mit n = 1 - 14 darstellt.
Die polymeren flüssigkristallinen Seitenkettenpolymeren können auch das Produkt einer Polykondensation sein:
Sie können z. B. dem Polyester oder Polyamid-Typ III angehören

$$\left[ - Z - \overset{O}{\overset{\|}{C}} - \overset{XY}{\overset{|}{T}} - \overset{O}{\overset{\|}{C}} - ZR_4 \right]_{\bar{p}} \qquad \text{III}$$

worin T eine Kohlenwasserstoffrest, insbesondere eine Alkylengruppe mit 1 - 2 Kohlenstoffatomen oder einen aromatischen Rest, Z Sauerstoff oder einen Rest

$$- \overset{|}{N} - R_2$$

und $R_4$ einen Kohlenwasserstoffrest entsprechend dem Diol der Ausgangsverbindung, mit 2 bis 20 Kohlenstoffatomen, insbesondere einen aromatischen, speziell einen benzylischen Rest bedeutet und -X-Y- die für die allgemeine Formel I angegebenen Bedeutungen besitzen. Genannt seien die Polymeren, in denen die mesogene Gruppe der Formel IB entspricht, sowie diejenigen in denen $R_3$für eine -CN Gruppe steht. Ferner sind bevorzugte Spacergruppen, in denen die verknüpfende Funktion VF eine Äthergruppe ist, die Spacergruppe der Formel $-[(CH)_2]_{6-8}$ entspricht.

Die Herstellung der Verbindung der Formel III ist an sich bekannt. Sie schließt sich an die üblichen Polykondensationsverfahren der Technik an. (Vgl. Houben-Weyl,4. Auflage Bd. 14/2 Georg Thieme Verlag 1961).

Schließlich können die Einheiten - X - Y auch durch polymeranaloge Umsetzung in bereits bestehende Polymerketten eingeführt werden. Solche Verfahren sind z. B. von C.M. Paleos et al. in J. Polym. Sci, Polym. Chem. Ed. 19 , 1427 (1981) und H. Finkelmann et al. in Makromol. Chem. Rapid Commun. 1 , 31, 733 (1980) angegeben worden.
Sie können beispielsweise durch Addition einer geeigneten Verbindung wie z. B. $H_2C = CH - Y$ (worin Y für die mesogene Gruppe steht) an eine reaktive bzw. aktivierbare Hauptkette erhalten werden, z. B. an Poly[oxy(methylsilylen)].

Im allgemeinen liegt das Molekulargewicht der polymeren Flüssigkristalle PFK im Bereich $\bar{M}_w - 10^3$ bis $10^5$, im allgemeinen im Bereich 5 000 - 200 000, vorzugsweise um 100 000 (Bestimmung durch Gel-Permeationschromatographie).
Die Viskositäten in der isotropen Phase liegen - als Richtwert - im Bereich 0,4 Pa.s ($10^4$ Poise).
Die Glastemperatur ($T_g$) der erfindungsgemäß verwendeten flüssigkristallinen Polymeren liegt im allgemeinen im Bereich von - 40 bis 110° C, insbesondere im Bereich von -10 bis 80° C. (Zur Glastemperatur $T_g$:

Vgl. I. Brandrup und E.H. Immergut, Polymer Handbook 2nd Ed. II - 139 J. Wiley, 1975).

Die Vorrichtung

Das erfindungsgemäße Verfahren wird vorteilhafterweise mittels der im folgenden beschriebenen Vorrichtung durchgeführt:

Das für den Informationsspeicherprozeß vorgeschlagene flüssigkristalline Polymere ist ein seinem Absorptionsverhalten auf die Wellenlänge des Schreiblasers anzupassen. Dies geschieht z.B. entweder durch Zumischen eines geeigneten Farbstoffs oder durch Einpolymerisieren desselben in die Polymerkette. Dabei kann das Farbstoffm olekül selbst mesogenen Charakter aufweisen. Vorzugsweise kann ein polymerer Flüssigkristall eingesetzt werden, dessen mesogene Gruppen selbst im geforderten Wellenlängenbereich absorbieren, der also dem Extremfall eines zu 100 % einpolymerisierten mesogenen Farbstoffs entspricht. Die erforderliche Extinkion des Speichermediums wird somit über die Farbstoffkonzentration eingestellt.

Geeignete Farbstoffe sind aus der Literatur bekannt. Als geeigente Farbstoffe zum Einmischen in die flüssigkristalline Phase werden solche genannt, die eine Reihe von Bedingungen erfüllen. (Vgl. z. B. J. Constant et al., J.Phys.D: Appl. Phys. Vol. 11 . S. 479 ff (1978).

F. Jones et al. Mol. Cryst. Liq. Crstal, Vol. 60 , S. 99 ff, 1980, EP-A 43 904, EP-A 55 838, EP-A 65 869. Die Farbstoffe sollen unter der Wirkung eines elektr. Feldes nicht ionisieren, sollen einen möglichst hohen molekularen Extinktionskoeffizienten und gleichzeitig eine gute Löslichkeit in der verwendeten Flüssigkristallmatrix (d.h. dem Speichermedium) haben und müssen chemisch/photochemisch stabil sein. Farbstoffe mit entsprechenden Eigenschaften finden sich z. B. in der Klasse der Anthrachinone (Vgl. EP-A 56 492, EP-A 44 893, EP-A 59 036, EP-A 54 217).

Geeignete Azofarbstoffe werden z. B. in der DE-A 34 06 209 angegeben. Der Anteil der Farbstoffe an dem Speichermedium liegt vorteilhafterweise im Bereich 1 bis 50 Gew.-%.

Polymere mit mesogenen Gruppen und Farbstoffresten in den Seitenketten sind Gegenstand der EP-A 7 574, EP-A 90 282, EP-A 1 40 133 vgl. auch H. Ringsdorf, H.W. Schmidt Makromol. Chem. 185 , 1327 - 1334 (1984); B. Reck, H. Ringsdorf Makromol. Chem. Rapid Commun. 6 , 291 (1985). Analog den vorstehend erläuterten polymeren Flüssigkristallen PFK der Formel I können repetierende Einheiten

$$-A-\underset{|}{B}-$$

die Hauptkettenelemente der farbstoffhaltigen Monomereinheiten bilden.

Die entsprechenden Monomeren A' = B' - X - Y' enthalten demnach den Farbstoffrest in der Gruppe Y'.

Als Beispiel einer mesogenen Gruppe M, die gleichzeitig einen Farbstoffrest darstellt sei die Gruppe

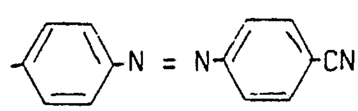

genannt. Vorteilhaft ist gleichzeitig eine Spacergruppe - $(CH_2)_6$-. Das Polymer kann im Prinzip in Form einer dünnen Schicht (Film) oder eines Laminats, als Beschichtung einer festen oder biegsamen Matrixschicht angewendet werden. Die Dicke des die polymeren Flüssigkristalle enthaltenden bzw. daraus bestehenden Films liegt vorteilhafterweise im Bereich $10^{-3}$ bis $10^{-6}$ m. In der hier angeführten Ausbildung (Vgl. Fig. 1 ) umfasst die erfindungsgemäße Vorrichtung eine Registrierzelle (1), bestehend aus zwei planparallel angeordneten transparenten Platten (2), vorzugsweise Glasplatten im geeigneten Abstand, im allgemeinen unterhalb 1 mm, vorzugsweise bei ca. 10 µm. Die Grundfläche beträgt einige $cm^2$ bis $dm^2$. Die beiden Innenflächen der Glasplatten (2) waren mit $InO_2/SnO_2$ leitfähig bedampft und leitender Kontakt nach außen war hergestellt worden. Die derart präparierten Glasplatten (2) wurden mit Hilfe eines temperaturstabilen Klebers, beispielsweise eines Silikonklebers so aneinander fixiert, daß ein zellenartiger leerer Innenraum mit jeweils nur einem Einlaß und Auslaß von einigen mm Breite gebildet wird.

Der gewünschte Abstand der beiden Glasplatten (2) wird dabei durch zwei geeignete Abstandshalter (3) der passenden Abmessung, vorzugsweise aus Polyimid-Kunststoft,fest eingestellt. Die Registrierzelle weist weiterhin Elektroden (4) auf. Nach Antrocknen des Klebers wird die Zelle auf einer heizbaren Einrichtung mit dem im isotropen Zustand befindlichen, flüssigkristallinen Polymeren, vorzugsweise der Formel I gefüllt.

Durch Kapillarwirkung bedingt füllt sich so der noch freie Zellenraum vollständig mit der Polymerschmelze.

Der Vorteil des Vorgehens gegenüber der Verwendung einer noch teilweise offenen Zelle liegt u. a. darin, daß der Einschluß von Luftblasen zuverlässig verhindert wird. Außderdem können so mit geringem Aufwand standardisierte Zellen-Rohlinge mit innerhalb gewisser Grenzen variabler Geometrie (Außenabmessungen, Distanzen) hergestellt werden, die (vgl. Fig. 1 ) dann bei Bedarf in einem zweiten Schritt in angegebener Weise mit den entsprechenden flüssigkristallinen Polymeren befüllt werden können. Die Orientierung erfolgt in an sich bekannter Weise durch Anlegen eines orientierten Felds (alignment field), insbesondere eines magnetischen und speziell eines elektrischen Felds oder über Oberflacheneffekte. *)Im Falle der (bevorzugten) Anwendung des elektrischen Feldes wird an die so gefüllte Registrierzelle (1) bei Temperaturen von oberhalb $T_g$ (Definition siehe oben) eine sinusförmige Wechselspannung (Richtwerte V = 500 V;$\nu$ = 1 k Hz) angelegt und unter Beibehaltung der angelegten Spannung auf Zimmertemperatur abgekühlt. Es resultiert ein absolut transparenter Flüssigkristallfilm, der sich rein visuell nicht von dem im isotropen Zustand befindlichen Material unterscheidet. Die Glastemperatur $T_g$ des flüssigkristallinen Polymeren liegt über der Raumtemperatur $T_a$. Als Raumtemperatur sei eine Temperatur von 20°C angenommen. Das Auslesen der Information kann durch Beleuchten des Polymerfilms mit monochromatischen kohärentem Licht erfolgen. Zur Einspeicherung der Information sind verschiedene Orientierungsmöglichkeiten des flüssigkristallinen Polymerfilms in der erfindungsgemäßen Vorrichtung (vgl. Fig. 1 ) möglich:

1) Die mesogenen Gruppen werden parallel zur Flächennormale der polymeren Filmschicht einheitlich ausgerichtet. Dies kann durch Anlegen eines elektrischen Wechselfeldes an die mit (transparenten) Elektroden beschichteten Platten (2), wobei das elektrische Feld parallel zur Normale der polymeren Filmschicht liegt, durch Anlegen eines Magnetfeldes oder durch Oberflächenbehandlung geschehen.

2) Die mesogenen Gruppen werden parallel oder zur Filmebene gekippt und parallel zu einer makroskopisch vorgegebenen Richtung orientiert. Dies kann entweder durch Beschichtung der Platten (2) mittels eines geeigneten Materials wie Polyimid und durch Strukturieren dieser Beschichtung entlang der gewünschten Vorzugsorientierung oder durch geeignete Schrägbedampfung der Substrate z. B. mit Siliziumoxid geschehen. *)

In beiden Fällen 1) und 2) erfolgt die Orientierung im flüssigkristallinen Zustand.

Die Orientierung wird durch Abkühlen in den Glaszustand eingefroren. Die wie oben angegeben hergestellte Registrierzelle (1) bildet das eigentliche Speichermedium für das Einspeichern optischer Information. Das Verfahren basiert im allgemeinen auf der lokalen, selektiven Variation des Ordnungszustands der polymeren Flüssigkristallmoleküle in einem diese enthaltenden Speichermedien.

Der im Speichermedium enthaltene Flüssigkristallfilm kann in makroskopisch orientierter oder desorientierter Form vorliegen. Die Variation des Ordnungszustands kann durch lokale elektrische, magnetische oder oberflächenwirksame Felder geschehen. Dabei kann das Speichermedium lokal oder insgesamt mit der Wärmequelle erwärmt werden. Wenn die Wärmequelle selektiv lokal wirkt, kann die Variation des Ordnungszustands durch eine über die gesamte Dimension des Speichermediums hinweg wirkendes elektrisches, magnetisches oder oberflächenwirksames Feld induziert werden. Besonders vorteilhafte Anwendungen basieren auf dem Streuzentreneffekt und nichtlinearen optischen Effekt (optisch induzierter Frederiks-Übergang).

- Nicht-linearer optischer Effekt (Optisch-induzierte Frederiks-Transition)

Das elektrische Feld der linear polarisierten Laser-Schreiblichtquelle induziert aufgrund der positiven Polarisierbarkeitsanisotropie von Flüssigkristallmolekülen eine lokale Modulation des Brechungsindex, die als Phasenobjekt durch einen zweiten Laserstrahl (linear polarisierte Welle eines Helium-Neon-Lasers) ausgelesen werden kann. Erreicht wird dies durch eine gezielte lokale **Reorientierung** der Flüssigkristallmoleküle im optischen Feld. Die Reorientierung (optisch induzierte Frederiks-Transition) erfolgt dabei oberhalb der Glastemperatur $T_g$ des flüssigkristallinen Polymeren in einer anisotropen Phase. Bei nachfolgendem Abkühlen friert die Brechungsindex-Struktur unterhalb $T_g$ als Phasenobjekt ein. Der Film kann dabei visuell völlig klar bleiben.

Die Temperatureinstellung kann extern durch Heizen erfolgen, wobei dann der Frequenz der Schreibwelle keine entscheidende Bedeutung zukommt. Vorzugsweise geschieht die Einstellung der Temperatur durch Absorption der Schreibwelle; die Abkühlung erfolgt beim Abschalten des Lasers. Dabei sollte die Schreibwelle zwei Bedingungen gleichzeitig erfüllen:

*) Ebenso kann die erforderliche Orientierung durch geeignetes Scheren oder Verstrecken erzeugt werden.

α) Die optische Feldstärke an den Interferenzmaxima muß oberhalb der "Frederiks threshold voltage" für das gewählte flüssigkristalline Polymer liegen.

β) Die Intensität muß so gewählt werden, daß durch Absorption eine Temperaturerhöhung an den Interferenzmaxima derart erfolgt, daß das Polymer über die Glastemperatur, jedoch **nicht** über die Temperatur des Phasenübergangs nematisch → isotrop ($T_{NI}$) erwärmt wird.

Durch geeignete Abstimmung von Laserwellenlänge und flüssigkristallinen Polymeren sind neben reiner Binärinformation (maximal mögliche Reorientierung) verschiedene Reorientierungsgrade möglich, was einer kontinuierlichen Phasenmodulation entspricht.

Ein industriell äußerst interessanter Aspekt des vorliegenden Verfahrens ist darin zu sehen, daß es gelingt ein Phasenobjekt mit hohen Beugungseffizienzen zu erzeugen, wie es für die optische Analogtechnik von entscheidender Bedeutung ist (Konventionelle Holographie, synthetische Holographie).

Der Versuchsaufbau zur Beurteilung der Speichereigenschaften der beschriebenen Registrierzelle basiert auf einem Mach-Zehnder-Interferometer (vgl. Encyclopädie Naturwissenschaft und Technik Bd. 2, Verlag Moderne Industrie, 1980). Hiermit lassen sich durch Überlagerung zweier linear polarisierter ebener Teilwellen sinusförmige Intensitätsgitter mit Strichabständen zwischen 100 µm und 1,0 µm erzeugen. In Verbindung mit einer Konvexlinse wird durch Überlagerung einer Ebene mit einer Kugelwelle die Intensitätsverteilung analog einer Fresnel'schen Zonenplatte realisiert.

Löschen der eingespeicherten Information

Grundsätzlich kann die eingespeicherte Information durch Temperaturerhöhung (über $T_{NI}$) und Abkühlen im elektrischen oder magnetischen Feld wieder gelöscht werden. Das Löschen von eingespeicherter Information kann lokal durch Temperaturerhöhung und nachfolgende Abkühlung im elektrischen oder magnetischen Feld unter Wiederherstellung des ursprünglichen Orientierungszustands im lokalen Bereich wiederhergestellt werden. Alternativ kann auch die gesamte eingegebenen Information gelöscht und der Urzust and wiederhergestellt werden, indem man die Temperatur des Speichermediums erhöht und im elektrischen oder magnetischen Feld abkühlt.

Vorteilhaft wird dabei wie folgt vorgegangen:

Analog der Vorbereitung für den ersten Einschreibvorgang wird die in den flüssigkristallinen Polymeren eingespeicherte Information durch Aufheizen der Registrierzelle (1) über $T_g$ und nachfolgendes Abkühlen bei angelegter Wechselspannung (Richtwerte 500 V, $\nu$ = 1 k Hz) gelöscht. Nachdem der Einschreib- und Löschvorgang mehrfach wiederholt worden war, stand fest, daß bei keinem der durchgeführten Schritte irreversible Veränderungen an der Registrierzelle auftreten.

Reversible analoge Datenspeicherung

(Vgl. Abbildung 1 - 4)

Wie bereits ausgeführt, bietet die Anwendung des nicht-linearen optischen Effekts die Möglichkeit auf optischem Wege Daten analog zu speichern, sie auf optischem Wege zu lesen, bei Bedarf wieder zu löschen und wiederholt Daten einzuschreiben. Die Datenspeicherung erfolgt mittels holographischer Methoden in dem erfindungsgemäßen Speichermedium. In der Regel betrifft die zu speichernde Information abbildungsfähige materielle Strukturen, z.B. Gegenstände oder zweidimensional organisierte Gegenstände wie Druckseiten oder graphische Gebilde. Hierzu wird die zu speichernde Struktur mittels einer kohärenten, monochromatischen Lichtquelle beleuchtet. Das Interferenzmuster, das durch Richtung, Amplitude und Phasenlage des von der zu speichernden Struktur gestreuten Lichts relativ zu einer von derselben Lichtquelle stammenden Referenzlichtwelle bestimmt wird, wird in dem vorteilhaft makroskop orientierten Film aus flüssigkristallinem Polymer holographisch registriert und gespeichert. (Vgl. Das Speichermedium). Die Stärke des flüssigkristallinen Polymerfilms liegt vorteilhaft auch hier zwischen 1 und 20 µm. Die planparallelen, transparenten Platten können aus durchsichtigen Kunststoffen wie Polymethacrylsänne methylester (PMMA) oder vorzugsweise aus anorganischen Gläsern hergestellt sein.

Vorteilhafterweise befinden sich im Speichermedium Farbstoffe. Die Farbstoffmoleküle können dabei Bestandteile des flüssigkristallinen Polymeren sein oder sie können dem Speichermedium beigemischt und darin verteilt sein. Die Glastemperatur $T_g$ des flüssigkristallinen Polymeren liegt über der Raumtemperatur $T_g$. Das Auslesen der Information kann durch Beleuchten des Polymerfilms mit monochromatischem

kohärentem Licht erfolgen. Zur Einspeicherung der Information sind verschiedene Orientierungsmöglichkeiten des flüssigkristallinen Polymerfilms in der erfindungsgemäßen Vorrichtung (vgl. Fig. 1) möglich:

1) Die mesogenen Gruppen werden parallel zur Flächennormale der polymeren Filmschicht einheitlich ausgerichtet. Dies kann durch Anlegen eines elektrischen Wechselfeldes an die mit (transparenten) Elektroden beschichteten Platten (2), wobei das elektrische Feld parallel zur Normale der polymeren Filmschicht liegt, durch Anlegen eines Magnetfeldes oder durch Oberflächenbehandlung geschehen.

2) Die mesogenen Gruppen werden parallel oder zur Filmebene gekippt und parallel zu einer makroskopisch vorgegebenen Richtung orientiert. Dies kann entweder durch Beschichtung der Platten (2) mittels eines geeigneten Materials wie Polyimid und durch Strukturieren dieser Beschichtung entlang der gewünschten Vorzugsorientierung oder durch geeigneter Schrägbedampfung der Substrate mit Siliziumoxid geschehen. *)

In beiden Fällen 1) und 2) erfolgt die Orientierung im flüssigkristallinen Zustand.

Die Orientierung wird durch Abkühlen in den Glaszustand eingefroren.

Die Speicherung erfolgt in der oben beschriebenen Weise, wobei als monochromatische Lichtquelle ein Laser verwendet wird, dessen Wellenlänge im Absorptionsbereich des Speichermediums liegt. Ausgelesen wird mittels eines Lasers, dessen Wellenlänge in viel geringerem Maße vom Speichermedium absorbiert wird. Das Einspeichern und Auslesen kann dabei bei Zimmertemperatur am festen Film erfolgen. Die Löschung der Information erfolgt durch Aufheizen der Probe in dem anisotropen oder isotropen Bereich oberhalb der Glastemperatur $T_g$.

## Reversible digitale Datenspeicherung

Eine andere Ausgestaltung der Erfindung betrifft die digitale Datenspeicherung auf optischem Wege, wobei auch hier das Auslesen auf optischem Wege, das Löschen und Wiedereinschreiben von Information vorgesehen ist. Dabei wird in dem optisch klaren, vororientierten flüssigkristallinen Polymerfilm des Speichermediums mittels eines monochromatischen Laserstrahls eine digitale Phasenstruktur erzeugt. Laserstrahl und Speichermedium werden in definierter Weise relativ zueinander bewegt und die Intensität des Laserstrahls moduliert. Das Auslesen der gespeicherten Information erfolgt durch definierte relative Bewegung des Speichermediums und eines Laserstrahls konstanter Intensität und geeigneter Wellenlänge, der die eingespeicherte Information unbeeinflußt läßt.

Die technische Vorbereitung des Speichermediums (Ausrichtung der Polymeren) geschieht analog der reversiblen analogen Datenspeicherung. Die Speicherung erfolgt in der oben beschriebenen Weise, wobei als monochromatische Lichtquelle ein Laser verwendet wird, dessen Wellenlänge im Absorptionsbereich das Speichermediums liegt. Ausgelesen wird mittels eines Lasers, dessen Wellenlänge in viel geringerem Maße von dem verwendeten Speichermedium absorbiert wird. Das Einspeichern und Auslesen kann dabei bei Zimmertemperatur am festen Film erfolgen. Die Löschung der Information erfolgt durch Aufheizen der Probe in den anisotropen oder isotropen Bereich oberhalb der Glastemperatur $T_g$.

## Reversible synthetische Holographie

Hierbei wird in der oben (für die reversible digitale Datenspeicherung) beschriebenen Weise auf digitalem Wege, durch definierte Relativbewegung von Schreibstrahl und Speichermedium, eine Phasenstruktur in einem vororientierten Flüssigkristall-Kunststoffilm erzeugt. Die Reproduktion erfolgt nun **nicht** wie im Fall der digitalen Speicher durch definierte Relativbewegung von Lesestrahl und Speichermedium, sondern durch vollständigs Ausleuchten des synthetischen Hologramms mit einer Referenzwelle. Die notwendige Information zur Ermittlung der erforderlichen Intensitätsmodulation ist vorher rechnerisch zu ermitteln. Das beschriebene Verfahren ermöglicht die Herstellung von Phasenstrukturen mit definierten optischen Eigenschaften, wie z. B. Linsen u. a.. Da dies rechnerisch in digitaler Form geschieht, können komplizierte Verarbeitungsprozesse (Glasschliff, Politur) erheblich vereinfacht werden. Sehr wesentlich ist auch das geringe Gewicht der auf dieser Weise hergestellten optischen Komponenten (Brillengläser, Linsen).

*) Ebenso kann die erforderliche Orientierung durch geeignetes Scheren oder Verstrekken erzeugt werden.

Vorteilhafte Wirkung

Das erfindungsgemäße Verfahren und die darauf ausgerichtete Vorrichtung zur reversiblen optischen Datenspeicherung eignen sich vorzüglich zur Anwendung auf dem Gebiet der reversiblen digitalen Informationsspeicherung (EDRAW). Eine weitere außerordentlich interessante Anwendungsmöglichkeit eröffnet sich auf dem Feld der analogen Informationsverarbeitung (Holographie). Deren Einsatzgebiet ist vorzüglich in der industriellen Prozeßsteuerung zu erblicken. Mit der optischen Analogtechnik lassen sich wichtige Phasen der Produktkontrolle wie Erkennen, Sortieren und Prüfen auf der Grundlage der kohärent optischen Korrelation sehr schnell und effektiv bewerkstelligen.

Herstellung der flüssigkristallinen Polymeren

Die erfindungsgemäß anwendbaren Polymeren, insbesondere die der Formel I können auf an sich bekannte Weise hergestellt werden: Hingewiesen sei auf die DE-A 27 22 589, DE-A 28 31 909, DE-A 30 20 645, DE-A 30 27 757, DE-A 32 11 400, EU-A 90 282. Typ. Direktverknüpfung Spacer - Mesogene Gruppe. Als Beispiel sei die Herstellung von Verbindungen des Typs IA beschrieben. (Vgl. V.P. Shibaev et al. Eur. Polym. J. 18 , 651 (1982)): Soweit im weiteren Symbole verwendet wurden, entsprechen sie den oben angegebenen Bedeutungen. Dabei kann von einer Verbindung der Formel III

$$Br - (CH_2)_{n'} - COOH \qquad III$$

worin n' gleich n - 1 bedeutet
mit einem anorganischen Säurechlorid wie $SOCl_2$ vorzugsweise in DMF,in die Verbindung IV überführt werden.

$$Br - (CH_2)_{n'} - COCl \qquad IV$$

Diese kann in einer Friedel-Crafts-Reaktion, beispielsweise in Nitrobenzol mit Diphenyl in die Verbindung der Formel V

$$Br - (CH_2)_{n'} - CO - C_6H_4 - C_6H_5 \qquad V$$

überführt werden, die sich z. B. mit Lithium-Aluminium-hydrid zur Verbindung VI reduziert

$$Br - (CH_2)_n - C_6H_4 - C_6H_5 \qquad VI$$

Diese kann mit $Cl_2CHOC_4H_9$ und Titantetrachlorid zur Verbindung VII

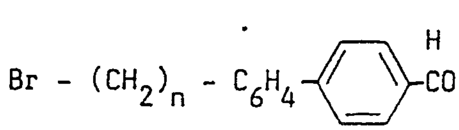

VII

umgesetzt werden. Die Verbindung VII kann mit Hydroxylamin-salz vorteilhafterweise in Anwesenheit einer Base wie Pyridin zum Oxim umgesetzt und dieses durch Wasserabspaltung, beispielsweise mit Hilfe eines Anhydrids wie Acetanhydrid in das Nitril VIII überführt werden

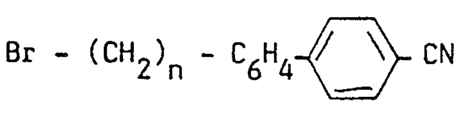

VIII.

Durch Umsetzung eines Salzes der (Meth)acrylsäure, beispielsweise im DMF mit Verbindung VIII erhält

man die Verbindung vom Typ IAa

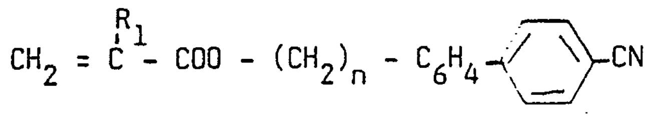 IAa

worin $R_1$ für Wasserstoff oder Methyl steht.

Unmittelbar analog läßt sich z. B. aus der Verbindung V und einem Salz der (Meth)acrylsäure die Verbindung IAb

$$CH_2 = \overset{R_1}{\overset{|}{C}} - COO - (CH_2)_n - C_6H_4 - C_6H_5 \qquad \text{IAb}$$

herstellen.

Typ: Verknüpfung Spacer - Mesogene Gruppe über eine Ätherbrücke.

Als Beispiel sei die Herstellung einer Verbindung vom Typ IA beschrieben (vgl. V. P Shibaev loc. cit., N.A. Plate, V. P. Shibaev J. Polym. Sci. Polym. Sympos (IUPAC 1978) 67 , 1 (1980)

Die Verbindung IV wird, z. B. mit Lithium-aluminiumhydrid in Äther zur Verbindung IX reduziert

$$Br - (CH_2)_n - OH \qquad \text{IX}$$

die mit der Verbindung XI

$$KO - C_6H_4 - C_6H_4 - CN \qquad \text{XI}$$

beispielsweise in Methanol zur Verbindung XII umgesetzt wird

$$HO - (CH_2)_n - O - C_6H_4 - C_6H_4 - CN \qquad \text{XII}$$

Die Hydroxyverbindung XII wird mit dem Chlorid der (Meth)acrylsäure in Anwesenheit eines Säureakzeptors wie z. B. einem tert. Amin in die Verbindung IAc überführt

$$CH_2 = \overset{R_1}{\overset{|}{C}} - COO - (CH_2)_n - O - C_6H_4 - C_6H_4 - CN \qquad \text{IAc}$$

Eine große Variabilität in Bezug auf die Strukturen IA und IE - IJ erlaubt das folgende Syntheseverfahren (M. Portugall, H, Ringsdorf, R. Zentel Makromol. Chem. 183 , 2311 (1982); H. Ringsdorf, A. Schneller, Brit. Polym. J. 13 , 43 (1981).

Dabei wird aus der Verbindung XIII

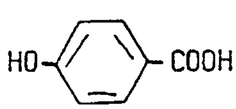 XIII

durch Umsetzung mit der Verbindung XIV in Gegenwart von Base

$$HO - (CH_2)_n - Cl \qquad \text{XIV}$$

die Säure XV

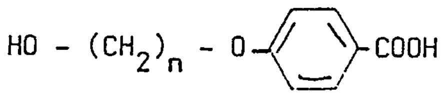 XV

hergestellt. Diese wird mit der (Meth)acrylsäure unter Säurekatalyse beispielsweise mit p- Toluolsulfonsäure in Chlorform in den (Meth)acrylsäureester XVI

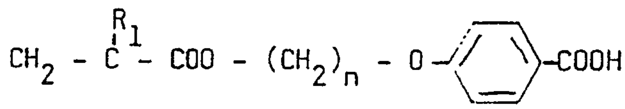 XVI

überführt. Die Verbindung XVI läßt sich z. B. analog III ins Säurechlorid überführen, das sich mit Phenol bzw. mit in p-Stellung substituierten Phenol in die Verbindung IE

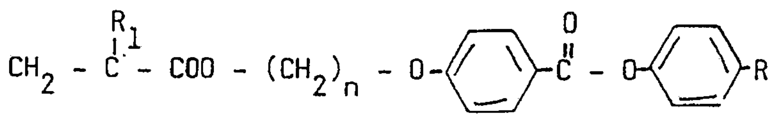 IE

bzw. die Verbindungen IE, IF, IG, IH, IJ überführen lässt.

Typ: Verknüpfung Spacer-Mesogene Gruppe über eine Estergruppe:

Als Beispiel sei die Herstellung einer Verbindung vom Typ IA beschrieben (Vgl. Plate et al. loc. cit.; Shibaev et al. loc. cit.) das Verfahren ist aber für die mesogenen Reste IA - IJ generell anwendbar. Dabei kann ausgehend von Verbindung IV mit einem der mesogenen Gruppen entsprechenden para-Phenol umgesetzt werden, etwa zur Verbindung XVII

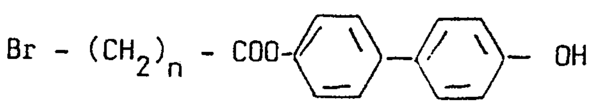 XVII

vorzugsweise in Gegenwart eines Säureakzeptors und in einem inerten Lösungsmittel wie THF.
Die weitere Umsetzung geschieht mit einem Salz der (Meth)acrylsäure Als Beispiel für Verbindungen, die ein chirales Zentrum R besitzen, sei die folgende Synthese erwähnt:
Man setzt ein Biphenyldiphenol der Formel XVIII

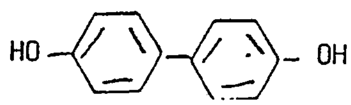 XVIII

mit dem Bromid der Formel XIX in Anwesenheit eines Alkalialkoholats

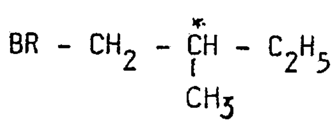 XIX

zu dem Phenol XX um.

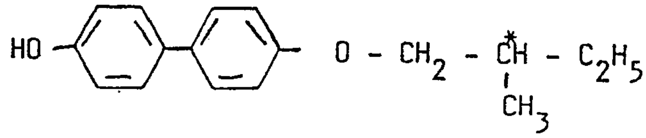 XX

Durch Umsetzung mit der Verbindung XIV in Ethanol unter Basenzusatz erhält man den Alkohol XXI

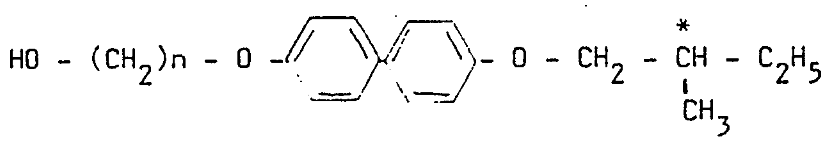 XXI

der mit (Meth)acrylsäure verestert wird.

Analog der Umsetzung XIV - XV kann aus der Verbindung XIV durch Umsetzung mit dem Phenol der Formel XXII in Gegenwart einer Base wie z. B. Pottasche in Aceton

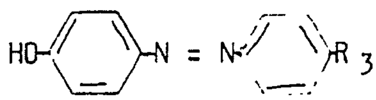 XXII

der Alkohol der Formel XXIII

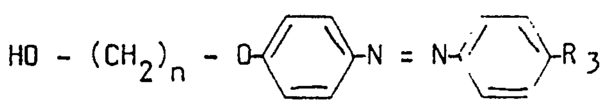 XXIII

hergestellt werden, der sich Umsetzung mit (Meth)acrylsäurechlorid in die Verbindung vom Typ IB überführen läßt.

Säureamide der Formel I sind beispielsweise durch Umsetzung von (Meth)acrylsäurechlorid mit dem Amin der Formel XXIV

$$\underset{R_2}{\underset{|}{HN}} - (CH_2)_n - COOH \qquad XXIV$$

zum (Meth)acrylsäureamid XXV

$$CH_2 = \overset{R_1}{\overset{|}{C}} - CO - \overset{R_2}{\overset{|}{N}} - (CH_2)_n - COOH \qquad XXV$$

erhältlich, das beispielsweise mittels Umsetzung mit

$$Cl - \overset{O}{\overset{\|}{C}} - OCH_3$$

in Gegenwart einer inerten Base mit einem Phenol, das die mesogene Gruppe enthält wie z. B. XXVI

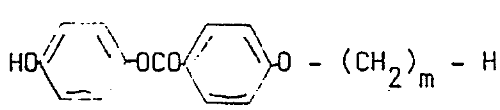 XXVI

in eine Verbindung des Typs ID übergeführt werden kann.

## Polymerisation der Monomeren

Bei der Polymerisation der Monomeren, beispielsweise vom Typ 1 kann nach den Polymerisationsmethoden des Standes der Technik verfahren werden.

(Vgl. Houben-Weyl, 4. Auflage Bd. 14/1, Georg Thieme Verlag 1961, H. Rauch-Puntigam, Th. Völker "Acryl- und Methacrylverbindungen, Springer-Verlag, Berlin 1967; Kirk-Othmer, 3rd Ed. Vol 18 , J. Wiley 1982 Schildknecht, Skeist, Polymerization Processes, Vol. 29 of "High Polymers" Pg 133 (Wiley- Interscience 1977).

Zur Polymerisation der Verbindungen der Formel I kommt die radikalische Polymerisation in Frage. Genannt sei beispielsweise die Polymerisation in Lösung,in Suspension/Emulsion oder als Perlpolymerisation.

Man verwendet z. B. die üblichen Radikalinitiatoren, beispielsweise Azo-oder Perverbindungen (Vgl. Rauch-Puntigam, Völker, loc. cit, oder Brandrup-Immergut, Polymer Handbook loc.cit.)in den dafür vorgesehenen Mengen, beispielsweise 0.1 bis 1 Gew.-% bezogen auf die Monomeren. (Prototypen : Azoisobutyronitril, Dibenzoylperoxid, Dilauroylperoxid). Gegebenenfalls kann die Polymerisation durch Anwendung von Reglern wie beispielsweise die üblichen Schwefelregler besteuert werden, im allgemeinen in Anteilen von 0,05 bis ca. 2 Gew.-% bezogen auf die Monomeren

(Vgl. auch DE-A 10 83 548)

Es gelten ebenso die übliche Temperaturführung und die Aufarbeitungsmethoden.

Das Verfahren sei anhand der (Meth)acrylverbindungen der Formel I

$$(A' = B' - X - Y \text{ entspricht } H_2 = \underset{R_1}{C} - \underset{O}{\overset{}{C}} - O - XY \quad \text{bzw.} \quad H_2 = \underset{R_1}{C} - \underset{O}{C} - \underset{R_2}{N} - XY)$$

näher erläutert.

Polymerisationsverfahren in Lösung:

Ca. 0,35 Mol des Monomeren der Formel I werden in 850 ml Toluol gelöst. Dazu gibt man 1,8 mMol Azoisobutyronitril und erwärmt ca. 8 Stunden unter einem Inertgas bei ca. 333° K.

Das entstandene Polymer wird durch Fällen mit einem Fällungsmittel wie z. B. 1200 mol Methanol gewonnen, abgetrennt und durch Lösen in einem geeigneten Lösungsmittel wie z. B. Dichlormethan und erneutes Fällen mit Methanol gereinigt.

Anschließend kann das so erhaltene Material, in der Regel von Pulverkonsistenz, im Wasserstrahlvakuum bei etwa 303° K bis zur Gewichtskonstanz getrocknet werden.

Durch thermische Analyse wird die Glastemperatur und die Klärtemperatur bestimmt.

## Ansprüche

1. Verfahren zur reversiblen optischen Informationsspeicherung in einem flüssigkristallinen Speichermedium mit mesogenen Seitengruppen mittels Laserlicht,
   dadurch gekennzeichnet,
   daß mittels linear polarisiertem Laserlicht über einen optisch nichtlinearen Effekt, auf Grund der positiven Polarisationsanisotropie der verwendeten Flüssigkristalle der selektiv zu einer Variation der räumlichen Orientierung der mesogenen Gruppen in einem Film aus einem flüssigkristallinen Seitenkettenpolymeren führt und eine lokale Änderung des Brechungsindex zur Folge hat, Information in Form eines optisch anisotropen Phasenobjektes eingespeichert wird, wobei sich der Film beim Einspeichern der Information im formstabilen Bereich unterhalb der Glastemperatur Tg der polymeren Flüssigkristalle oder im viskoelastischen Zustand oberhalb der Glastemperatur aber unterhalb des Übergangs von flüssigkristallin in isotrop der polymeren Flüssigkristalle in einer anisotropen Phase befindet.

2. Verfahren gemäß Anspruch 1, dadurch gekennzeichnet, daß das Speichermedium für ein entsprechendes nichtlineares optisches Verhalten geeignete und bezüglich der Wellenlänge des Schreiblasers in ihrem Absorptionsverhalten angepaßte Farbstoffe enthält.

3. Verfahren gemäß den Ansprüchen 1 und 2, dadurch gekennzeichnet, daß die optisch nichtlinearen Farbstoffe ausgewählt sind aus der Gruppe der Azobenzolfarbstoffe, Azoxyfarbstoffe, Azomethine oder

Silbene.

4. Verfahren gemäß den Ansprüchen 1 bis 3, dadurch gekennzeichnet, daß als Speichermedium ein makroskopisch orientierter poymerer Flüssigkristallfilm verwendet wird.

5. Verfahren gemäß den Ansprüchen 1 bis 3, dadurch gekennzeichnet, daß als Speichermedium ein makroskopisch desorientierter Flüssigkristallfilm verwendet wird.

6. Verfahren gemäß den Ansprüchen 1 bis 4, dadurch gekennzeichnet, daß zum Löschen von eingespeicherter Information und zur Wiederherstellung des makroskopisch orientierten Ausgangszustands lokal per Temperaturerhöhung zu nachfolgender Abkühlung im elektrischen oder magnetischen oder oberflächenwirksamen Feld der ursprüngliche Orientierungszustand in einem lokalen Bereich wiederhergestellt wird.

7. Verfahren gemäß den Ansprüchen 1 bis 4, dadurch gekennzeichnet, daß zum Löschen der eingegebenen Gesamtinformation und zur Wiederherstellung des makroskopisch orientierten Ausgangszustands die Temperatur des Speichermediums erhöht und im elektrischen, magnetischen oder oberflächenwirksamen Feld abgekühlt wird.

8. Verfahren gemäß den Ansprüchen 1, 3 und 5, dadurch gekennzeichnet, daß zum Löschen der eingegebenen Gesamtinformation und Wiederherstellung des makroskopisch desorientierten Zustands die Temperatur des Speichermediums über $T_{NI}$ hinaus erhöht und nachfolgend abgekühlt wird.

9. Verfahren gemäß den Ansprüchen 7 und 8, dadurch gekennzeichnet, daß die Temperaturerhöhung in eine anisotrope, flüssige Phase des verwendeten flüssigkristallinen Polymeren führt.

10. Verfahren gemäß den Ansprüchen 7 und 8, dadurch gekennzeichnet, daß die Temperaturerhöhung in die isotrope Phase des verwendeten flüssigkristallinen Polymeren führt.

11. Verfahren gemäß den Ansprüchen 1 bis 10, dadurch gekennzeichnet, daß flüssigkristalline Polymere ein Molgewicht $\overline{M}$ n im Bereich $10^3$ bis $10^5$ hat.

12. Verfahren gemäß den Ansprüchen 1 bis 11, dadurch gekennzeichnet, daß das Absorptionsverhalten des Speichermediums so gewählt ist, daß die Information mit einem Laserstrahl geeigneter Wellenlänge und geeigneter Intensität eingespeichert und mit einem anderen Laserstrahl anderer Wellenlänge ohne Störung der gespeicherten Information ausgelesen werden kann.

13. Verfahren gemäß den Ansprüchen 1 bis 12, dadurch gekennzeichnet, daß die mesogenen Seitenketten des flüssigkristallinen Polymeren solche vom smektogenen Typ darstellen.

14. Verfahren gemäß den Ansprüchen 1 bis 13, dadurch gekennzeichnet, daß die flüssigkristallinen Polymeren aus Monomeren aufgebaut sind, die dem Acrylatund/oder Methacrylattyp angehören.

15. Verfahren gemäß den Ansprüchen 1 bis 14, dadurch gekennzeichnet, daß die flüssigkristallinen Polymeren aus Monomeren aufgebaut sind, die dem Polyestertyp angehören.

16. Verfahren gemäß den Ansprüchen 1 bis 15, dadurch gekennzeichnet, daß sich der makroskopisch orientierte Film zwischen zwei übereinander angeordneten Platten oder Filmen befindet.

17. Verfahren gemäß den Ansprüchen 1 bis 16, dadurch gekennzeichnet, daß die verwendete Laserleistung im Bereich zwischen 10 $W/cm^2$ und 1 $mW/cm^2$ liegt.

18. Verfahren gemäß Anspruch 12, dadurch gekennzeichnet, daß das flüssigkristalline Polymer durch Einpolymerisieren einer farbstoffhaltigen Comonomereinheit in seinem Absorptionsverhalten der Emissionswellenlänge des Schreiblasers angepaßt ist.

19. Verfahren gemäß den Ansprüchen 12 bis 18, dadurch gekennzeichnet, daß die erforderliche Extinktion des Speichermediums über die Farbstoffkonzentration eingestellt wird.

## Claims

1. Process for the reversible optical storage of information in a liquid crystal storage medium with mesogenic side groups by means of laser light, characterised in that information is stored in the form of an optically anisotropic phase object, by means of linearly polarised laser light by an optically non-linear effect, on the basis of the positive polarisation anisotropy of the liquid crystals used, resulting selectively in a variation in the spatial orientation of the mesogenic groups in a film consisting of a liquid crystal side-chain polymer and leading to a local change in the refractive index, the film being in an anisotropic phase during the storage of the information in the structurally stable range below the glass transition temperature Tg of the polymeric liquid crystals or in the viscoelastic state above the glass transition temperature of the polymeric liquid crystals but below the transition from liquid-crystal to isotropic.

2. Process according to claim 1, characterised in that the storage medium contains dyestuffs which are suitable for corresponding non-linear optical behaviour and which have suitable absorption characteristics with regard to the wavelength of the recording laser.

3. Process according to claims 1 and 2, characterised in that the optically non-linear dyestuffs are selected from the group comprising the azobenzene dyes, azoxy dyes, azomethines or silbenes.

4. Process according to claims 1 to 3, characterised in that the storage medium used is a macroscopically oriented polymeric liquid crystal film.

5. Process according to claims 1 to 3, characterised in that the storage medium used is a macroscopically disorientated liquid crystal film.

6. Process according to claims 1 to 4, characterised in that in order to erase stored information and reestablish the macroscopically orientated initial state locally by temperature increase to subsequent cooling in an electrical or magnetic or surface-active field, the original state of orientation is re-established in a local area.

7. Process according to claims 1 to 4, characterised in that in order to erase all the information fed in and to re-establish the macroscopically orientated initial state, the temperature of the storage medium is increased and cooled in an electrical, magnetic or surface-active field.

8. Process according to claims 1, 3 and 5, characterised in that, in order to erase all the information fed in and to re-establish the macroscopically disorientated state, the temperature of the storage medium is increased beyond $T_{NI}$ and it is then cooled.

9. Process according to claims 7 and 8, characterised in that the temperature increase leads to an anisotropic liquid phase of the liquid-crystalline polymer used.

10. Process according to claims 7 and 8, characterised in that the temperature increase leads to the isotropic phase of the liquid crystalline polymer used.

11. Process according to claims 1 to 10, characterised in that the liquid crystalline polymer has a molecular weight $\overline{M}$ n in the range from $10^3$ to $10^5$.

12. Process according to claims 1 to 11, characterised in that the absorption characteristics of the storage medium are selected so that the information can be stored using a laser beam of suitable wavelength and suitable intensity and can be retrieved with another laser beam of a different wavelength without affecting the information stored.

13. Process according to claims 1 to 12, characterised in that the mesogenic side chains of the liquid crystalline polymer are of the smectogenic type.

14. Process according to claims 1 to 13, characterised in that the liquid crystalline polymers are synthesised from monomers belonging to the acrylate and/or methacrylate type.

15. Process according to claims 1 to 14, characterised in that the liquid crystalline polymers are synthesised from monomers of the polyester type.

16. Process according to claims 1 to 15, characterised in that the macroscopically orientated film is located between two plates or films arranged one above the other.

17. Process according to claims 1 to 16, characterised in that the laser power used is in the range between 10 $W/cm^2$ and 1 $mW/cm^2$.

18. Process according to claim 12, characterised in that the liquid crystalline polymer is matched in its absorption characteristics to the emission wavelength of the recording laser by the polymerisation therein of a comonomer unit which contains dye.

19. Process according to claims 12 to 18, characterised in that the required extinction of the storage medium is obtained by means of the concentration of dye.

## Revendications

1. Procédé de mémorisation optique réversible d'informations dans un support de mémorisation cristallin liquide à groupes latéraux mésogènes au moyen de lumière laser, caractérisé en ce que des informations sont mises en mémoire sous forme d'un objet de phase optiquement anisotrope au moyen de lumière laser polarisée linéairement par un effet optiquement non linéaire basé sur l'anisotropie de polarisation positive des cristaux liquides utilisés, effet qui conduit sélectivement à une variation de l'orientation dans l'espace des groupes mésogènes dans un film en un polymère à chaînes latérales cristallin liquide et qui a pour conséquence une modification locale de l'indice de réfraction, le film se trouvant dans une phase anisotrope lors de la mise en mémoire des informations dans la gamme à forme stable au-dessous de la température de transition vitreuse Tg des cristaux liquides polymères ou à l'état visco-élastique au-dessus de la température de transition vitreuse, mais audessous du passage de l'état cristallin liquide à l'état isotrope des cristaux liquides polymères.

2. Procédé selon la revendication 1, caractérisé en ce que le support de mémorisation contient des colorants qui conviennent pour des caractéristiques optiques non linéaires appropriées et qui sont adaptés, en ce qui concerne leurs caractéristiques d'absorption, à la longueur d'onde du laser d'écriture.

3. Procédé selon la revendication 1 ou 2, caractérisé en ce que les colorants non linéaires optiquement sont choisis dans le groupe des colorants azobenzéniques, des colorants azoxyques, des azométhines ou des stilbènes.

4. Procédé selon l'une quelconque des revendications 1 à 3, caractérisé en ce qu'un film de cristaux liquides polymères macroscopiquement orienté est utilisé comme support de mémorisation.

5. Procédé selon l'une quelconque des revendications 1 à 3, caractérisé en ce qu'un film de cristaux liquides macroscopiquement désorienté est utilisé comme support de mémorisation.

6. Procédé selon l'une quelconque des revendications 1 à 4, caractérisé en ce que pour l'effacement d'informations mémorisées et pour le rétablissement de l'état initial orienté macroscopiquement, l'état d'orientation initial est rétabli dans une région locale par élévation locale de la température, suivie de refroidissement dans le champ électrique, magnétique ou agissant superficiellement.

7. Procédé selon l'une quelconque des revendications 1 a 4, caractérisé en ce que pour l'effacement de la totalité des informations mémorisées et le rétablissement de l'état initial macroscopiquement orienté, la température du support de mémorisation est élevée et celui-ci est refroidi dans le champ électrique, magnétique ou agissant superficiellement.

8. Procédé selon l'une quelconque des revendications 1, 3 et 5, caractérisé en ce que pour l'effacement de la totalité des informations introduites et le rétablissement de l'état macroscopiquement désorienté,

la température du support de mémorisation est élevée audelà de $T_{NI}$, puis le support est refroidi.

9. Procédé selon la revendication 7 ou 8, caractérisé en ce que l'élévation de température conduit à une phase liquide anisotrope du polymère cristallin liquide utilisé.

10. Procédé selon la revendication 7 ou 8, caractérisé en ce que l'élévation de température conduit à la phase isotrope du polymère cristallin liquide utilisé.

11. Procédé selon l'une quelconque des revendications 1 à 10, caractérisé en ce que le polymère cristallin liquide a un poids moléculaire $\overline{M}$ n dans la gamme de $10^3$ à $10^5$.

12. Procédé selon l'une quelconque des revendications 1 à 11, caractérisé en ce que les caractéristiques d'absorption du support de mémorisation sont choisies de telle sorte que les informations puissent être mises en mémoire avec un rayon laser de longueur d'onde appropriée et d'intensité appropriée et que les informations mémorisées puissent être lues sans être altérées avec un autre rayon laser ayant une autre longueur d'onde.

13. Procédé selon l'une quelconque des revendications 1 à 12, caractérisé en ce que les chaînes latérales mésogènes du polymère cristallin liquide représentent des chaînes du type smectogène.

14. Procédé selon l'une quelconque des revendications 1 à 13, caractérisé en ce que les polymères cristallins liquides sont composés de monomères qui appartiennent au type acrylate et/ou méthacrylate.

15. Procédé selon l'une quelconque des revendications 1 à 14, caractérisé en ce que les polymères cristallins liquides sont composés de monomères qui appartiennent au type polyester.

16. Procédé selon l'une quelconque des revendications 1 à 15, caractérisé en ce que le film orienté macroscopiquement se trouve entre deux plaques ou films disposés l'un au-dessus de l'autre.

17. Procédé selon l'une quelconque des revendications 1 à 16, caractérisé en ce que la puissance de laser utilisée se situe dans la gamme comprise entre 10 $W/cm^2$ et 1 $mW/cm^2$.

18. Procédé selon la revendication 12, caractérisé en ce que le polymère cristallin liquide est adapté, en ce qui concerne ses caractéristiques d'absorption, à la longueur d'onde d'émission du laser d'écriture par inclusion en liaison polymère d'un motif comonomère qui contient un colorant.

19. Procédé selon l'une quelconque des revendications 12 à 18, caractérisé en ce que l'extinction nécessaire du support de mémorisation est réglée au moyen de la concentration de colorant.

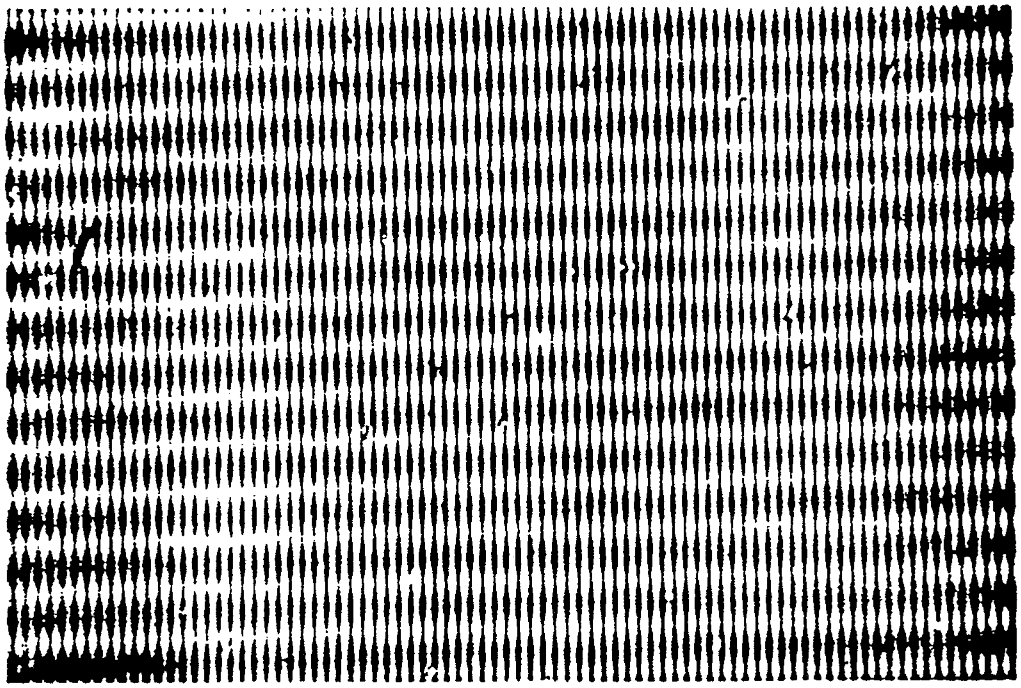

Abbildung 1:

Analog optisch aufgezeichnetes Hologramm
zweier ebener Wellen.
Die Kreuzgitterabstände betragen 4 µm bzw. 15 µm.

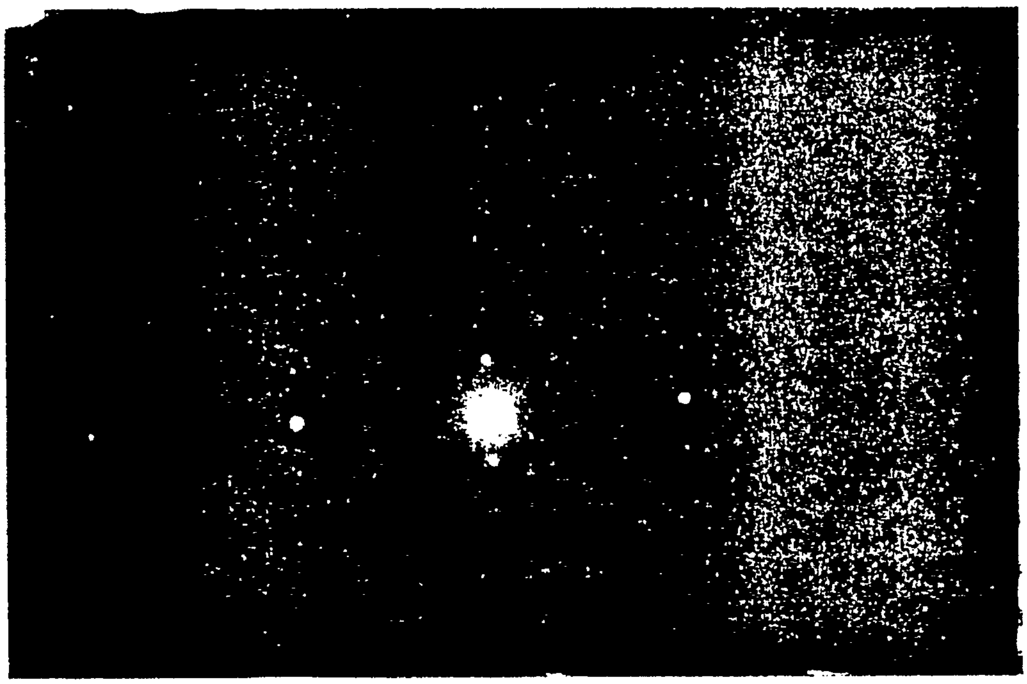

Abbildung 2:

Fraunhofer Beugungsbild des Kreuzgitters aus Abbildung 1.

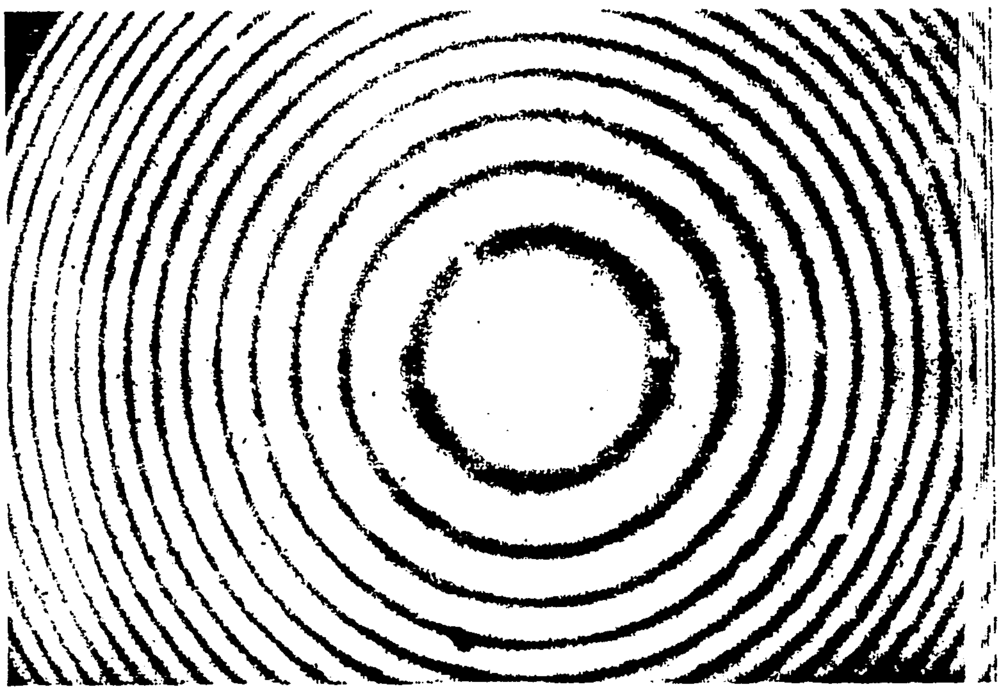

Abbildung 3:

Analog optisch aufgezeichnetes Hologramm einer Kugelwelle.
Der Zentrumsdurchmesser des Fresnel'schen Zonenbildes beträgt 200 µm.

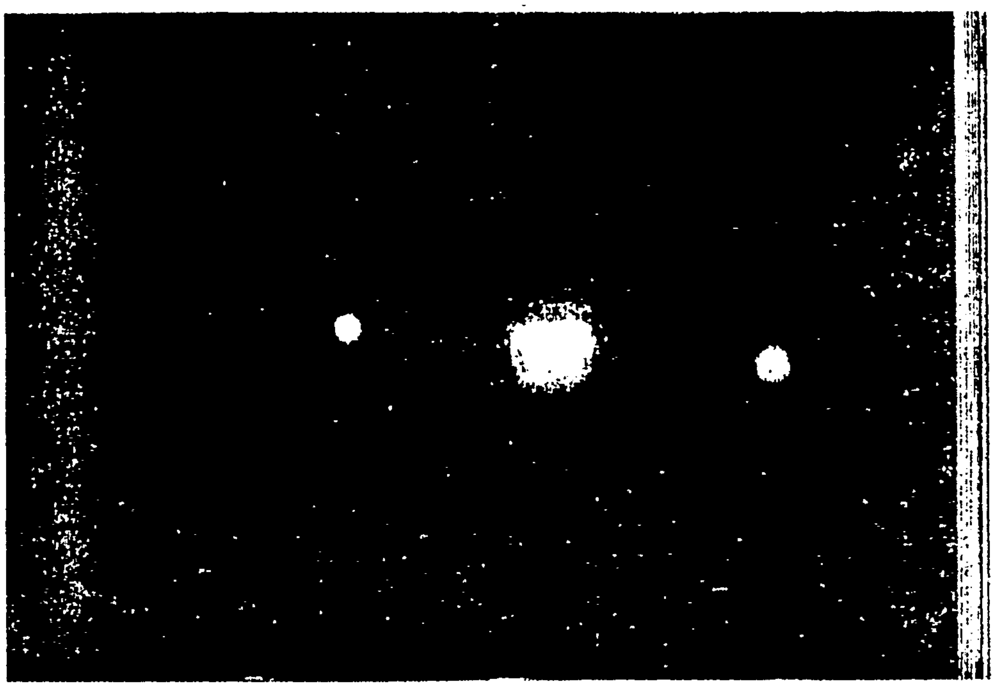

Abbildung 4:

Rekonstruktion der virtuellen und
reellen Objektkugelwellen.

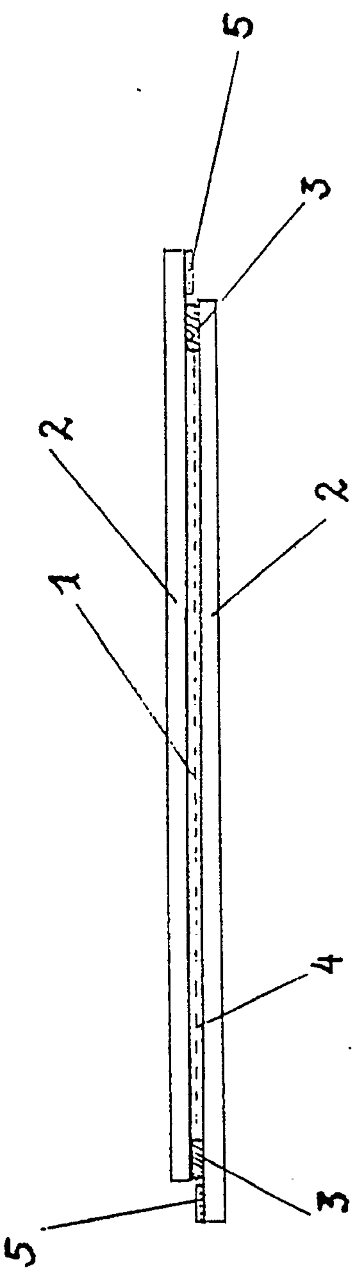


FIG. 1